# FASCICULE DE BREVET EUROPEEN

(11) **EP 2 839 302 B1**
(45) Date de publication et mention de la délivrance du brevet: **25.09.2019**
(21) Numéro de dépôt: 13721613.1
(22) Date de dépôt: 19.04.2013
(51) Int. Cl.: G01R 31/36

(54) **DISPOSITIF DE DETERMINATION D'UNE CARACTERISTIQUE D'UNE BATTERIE ET PROCEDE DE FONCTIONNEMENT D'UN TEL DISPOSITIF**
VORRICHTUNG ZUR BESTIMMUNG EINER EIGENSCHAFT EINER BATTERIE UND VERFAHREN ZUM BETREIBEN EINER SOLCHEN VORRICHTUNG
DEVICE FOR DETERMINING A PROPERTY OF A BATTERY AND METHOD FOR OPERATING SUCH A DEVICE

(30) Priorité: 19.04.2012 FR 1253609
(43) Date de publication de la demande: 25.02.2015
(73) Titulaire: Commissariat à l'Énergie Atomique et aux Énergies Alternatives, 75015 Paris (FR)
(72) Inventeur: HING, Sothun Eric, F-73000 Chambéry (FR); HA, Duy Long, F-73000 Chambéry Le Vieux (FR)
(74) Mandataire: Novaimo
(86) Numéro de dépôt international: PCT/EP2013/058223
(87) Numéro de publication internationale: WO 2013/156621

(56) Documents cités:
- DE-A1- 10 312 591
- US-A1- 2010 097 036

## Description

La présente invention concerne un procédé de fonctionnement d'un dispositif de détermination d'une caractéristique d'une batterie d'accumulateurs de stockage d'énergie électrique. L'invention concerne aussi un dispositif mettant en oeuvre un tel procédé de fonctionnement. L'invention concerne encore un système comprenant un tel dispositif et une batterie.

Habituellement, les batteries sont utilisées en charge et en décharge tout au long de leur vie selon des valeurs de paramètres ou caractéristiques définies ou supposées valables lors de leur mise en service. Au moins une partie de la gestion de la batterie repose sur les valeurs de ces paramètres ou caractéristiques.

Cependant, les valeurs de ces paramètres peuvent évoluer au fil de la vie ou du vieillissement de la batterie.

La gestion de la batterie quelle que soit son utilisation (appareil portable, voiture électrique, etc....) est un élément indispensable pour optimiser son fonctionnement, sa durée de vie et sa sécurité. La gestion du fonctionnement de la batterie est également indispensable pour fournir aux utilisateurs des informations fiables telles que notamment l'état de charge SOC (State Of Charge), l'état de santé SOH (State Of Health), l'état de sécurité SOS (State Of Safety) et l'autonomie disponible. L'état de charge SOC (ou capacité restante en %) est le rapport de la capacité restante Cr à un instant donné sur la capacité réelle totale disponible Cref. A noter que la capacité réelle totale disponible Cref évolue négativement au cours de la vie de service de l'accumulateur. Ceci est dû à l'usure de la batterie au cours de l'utilisation. L'état de santé SOH (ou état d'usure en %) est le rapport de la capacité réelle totale disponible Cref à un instant donné sur la capacité réelle totale disponible initiale CrefO mesurée au début de vie de l'utilisation de la batterie.

Cependant, dans le cas réel de l'utilisation de la batterie pour diverses applications, les valeurs de Cref et de Cr déterminées par le système de gestion du fonctionnement de la batterie peuvent être erronées du fait de différentes raisons :
- utilisation de la batterie en décharge partielle, c'est-à-dire absence de décharge complète lors de la vie de la batterie ;
- utilisation en charge partielle, c'est-à-dire absence de charge complète lors de la vie de la batterie ;
- erreur de mesure de tension et de courant, entraînant une erreur cumulée sur les valeurs déterminées de Cr et Cref lors de l'utilisation ;
- vieillissement et autodécharge en calendaire ;
- plantage du système de gestion du fonctionnement de la batterie.

En conséquence, les valeurs SOC et SOH sont impactées par les problèmes mentionnés ci-dessus, peuvent être erronées et éloignées des valeurs réelles. Il s'ensuit une gestion inappropriée du fonctionnement de la batterie, ce qui n'est pas souhaitable pour l'utilisateur.

Les documents DE10312591A1 et US2010/097036A1 de l'état de la technique sont pertinents.

Le but de l'invention est de fournir un procédé de fonctionnement d'un dispositif de détermination d'une caractéristique d'une batterie permettant de remédier aux problèmes évoqués précédemment et améliorant les procédés de fonctionnement connus de l'art antérieur. En particulier, l'invention propose un procédé de fonctionnement simple, peu coûteux et permettant d'éviter que des valeurs erronées soient prises en compte pour gérer le fonctionnement de la batterie.

La revendication indépendante 1 définit un procédé selon l'invention.

La caractéristique peut être l'état de santé de la batterie ou la capacité de la batterie, au moins une valeur de ladite caractéristique peut être sauvegardée dans une mémoire et, après détermination de la valeur réelle de la caractéristique, cette valeur réelle peut être enregistrée dans ladite mémoire. L'étape de détermination de la valeur réelle de la caractéristique de la batterie peut comprendre une phase de décharge de la batterie, notamment une phase de décharge complète ou partielle de la batterie, puis une phase de charge de la batterie, notamment une phase de charge complète ou partielle de la batterie.

L'étape de détermination de la valeur réelle de la caractéristique de la batterie peut comprendre une phase de charge complète de la batterie.

On peut déterminer l'intensité du courant de charge de la batterie pendant toute la phase de charge de la batterie et on peut utiliser cette intensité pour déterminer le niveau de la charge de la batterie à la fin de la phase de charge. L'étape de détermination de la valeur réelle de la caractéristique de la batterie peut comprendre une phase de décharge complète de la batterie.

On peut déterminer l'intensité du courant de décharge de la batterie pendant toute la phase de décharge de la batterie et on peut utiliser cette intensité pour déterminer le niveau de la charge de la batterie à la fin de la phase de décharge.

L'étape de réception d'une requête de détermination d'une valeur réelle de la caractéristique de la batterie peut comprendre la détection d'une échéance d'une temporisation déclenchée lors d'une étape de détermination précédente et/ou une détection d'une volonté de détermination exprimée par l'utilisateur du dispositif.

L'énergie issue de la batterie pendant la décharge de la batterie peut être :
- utilisée pour recharger au moins une autre batterie ; et/ou
- utilisée dans une habitation à laquelle le dispositif est électriquement connecté ; et/ou
- injectée sur un réseau électrique, notamment le réseau électrique commercial.

L'invention porte aussi sur un support d'enregistrement de données lisible par un calculateur sur lequel est enregistré un programme d'ordinateur comprenant des moyens logiciels de mise en oeuvre des étapes du procédé défini précédemment.

La revendication indépendante 12 définit un dispositif selon l'invention.

Selon l'invention, un système, notamment un véhicule automobile, comprend un dispositif défini précédemment, une batterie et un dispositif consommateur.

L'invention porte aussi sur un procédé intelligent comprenant un moyen de code de programme informatique adapté à la réalisation des étapes du procédé défini précédemment, lorsque le programme est exécuté sur calculateur ou automate.

Les dessins annexés représentent, à titre d'exemple, un mode de réalisation d'un procédé de fonctionnement selon l'invention et un mode de réalisation d'un dispositif selon l'invention.
La figure 1 est un schéma représentant un mode de réalisation d'un système selon l'invention.
La figure 2 est un synoptique d'un mode d'exécution d'un procédé de fonctionnement d'un dispositif selon l'invention.
La figure 3 est un diagramme détaillé représentant une procédure du mode d'exécution du procédé de fonctionnement.
La figure 4 est un diagramme illustrant plusieurs systèmes selon l'invention reliés à un réseau via des chargeurs.
La figure 5 est un diagramme illustrant un système selon l'invention relié à un réseau via un chargeur et une maison.

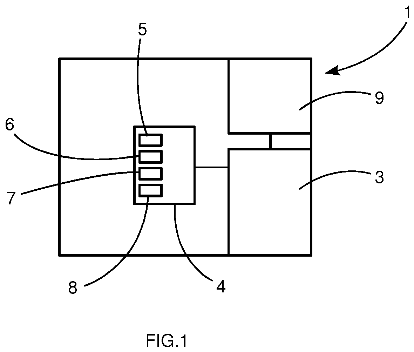

Un mode de réalisation d'un système selon l'invention est décrit ci-après en référence à la figure 1. Le système 1 comprend un dispositif 4 de détermination d'une caractéristique ou d'une valeur caractéristique d'une batterie 3, un dispositif 9 consommateur d'énergie de la batterie et la batterie 3 alimentant le dispositif. Le système peut être de toute nature. Il peut par exemple être un système portable comme un téléphone ou un ordinateur. Le système peut aussi être un véhicule automobile électrique ou hybride. Le dispositif 4 de détermination d'une caractéristique ou d'une valeur caractéristique peut comprendre une unité électronique, comme un calculateur. Le dispositif 4 de détermination permet notamment de commander la connexion de la batterie à un chargeur et/ou de commander la connexion de la batterie au dispositif consommateur 9. Le dispositif de détermination permet notamment de piloter des interrupteurs commandés assurant les connexions. Le dispositif de détermination comprend de préférence une interface homme-machine. Dans ce document, on utilise parfois le terme « caractéristique » pour « valeur de caractéristique ».

Le dispositif selon l'invention, en particulier l'unité électronique, comprend des moyens matériels et/ou logiciels régissant le procédé de fonctionnement selon l'invention, c'est-à-dire comprenant des moyens matériels et/ou logiciels de mise en oeuvre des étapes du procédé de fonctionnement selon l'invention. Notamment, les moyens matériels et/ou logiciels comprennent un élément 5 de réception d'une requête de détermination d'une valeur caractéristique d'une batterie, un élément 6 de détermination, en interrogeant un utilisateur, de la prochaine date à laquelle un dispositif consommateur 9 aura besoin d'énergie de la batterie, un élément 7 de vérification qu'il est possible de déterminer la valeur caractéristique de la batterie d'ici la prochaine date, un élément 8 de détermination de la valeur caractéristique de la batterie en réalisant une phase de charge et/ou de décharge de la batterie.

Les moyens matériels et/ou logiciels peuvent aussi comprendre un élément de détection d'un besoin de détermination d'une valeur d'une caractéristique de la batterie, un élément de prévision du besoin en énergie du dispositif, un élément de vérification de la possibilité de déterminer cette valeur de caractéristique vis-à-vis du besoin prévu en énergie du dispositif, un élément de détermination de la valeur de la caractéristique de la batterie.

Les moyens logiciels peuvent comprendre des programmes de calculateur ou d'ordinateur. La caractéristique comprend l'état de charge et/ou l'état de santé de la batterie.

L'élément 5 de réception d'une requête de détermination d'une valeur caractéristique d'une batterie peut comprendre un récepteur d'un signal, notamment un signal électrique, contenant une requête de détermination d'une valeur caractéristique. Cette requête peut être formulée par tout dispositif du système 1, notamment par un dispositif de gestion du fonctionnement de la batterie. Alternativement, la requête peut être formulée par un dispositif externe au système, notamment un utilisateur. Dans ce cas, l'utilisateur peut formuler la requête à l'aide de l'interface homme-machine.

L'élément de détection d'un besoin de détermination d'une valeur d'une caractéristique de la batterie peut comprendre un simple circuit de mesure de temps, un signal détectable étant émis par ce circuit dès qu'une durée supérieure à un seuil est dépassée depuis la dernière mise en oeuvre du procédé, en particulier depuis la dernière mise en oeuvre au cours de laquelle la batterie a été complètement déchargée puis complètement chargée. L'élément de détection peut complémentairement ou alternativement comprendre un élément de détection d'une volonté ou d'une action de l'utilisateur, cet élément étant par exemple un organe d'une interface homme-machine. Le signal émis par l'élément de détection est reçu par l'élément de réception d'une requête.

L'élément 6 de détermination de la prochaine date à laquelle un dispositif consommateur 9 aura besoin d'énergie de la batterie met de préférence en oeuvre une interrogation d'un utilisateur. Ainsi, un signal, par exemple visuel et/ou sonore, invite l'utilisateur à indiquer au dispositif la prochaine date à laquelle le dispositif consommateur aura besoin d'utiliser de l'énergie de la batterie. Par « date », on entend « date » au sens large, c'est-à-dire comme incluant les indications des heures, voire des minutes. Le signal est de préférence émis par l'interface homme-machine. Il peut consister en l'allumage d'un voyant réel ou virtuel, plus généralement en tout signe apparaissant sur un écran. L'utilisateur répond à l'interrogation en fournissant la date au dispositif. Ceci est de préférence également fait via l'interface homme-machine, notamment à l'aide d'un clavier réel ou virtuel ou tout autre moyen de saisie d'informations.

L'élément 7 de vérification qu'il est possible de déterminer la valeur caractéristique de la batterie d'ici la prochaine date utilise, la date actuelle, l'information de date évoquée précédemment et une information de durée d'une phase de détermination de la caractéristique pour déterminer cette possibilité. L'élément de vérification peut comprendre des moyens de calcul permettant de déterminer le temps de décharge de la batterie, et, éventuellement de déterminer le temps de charge complète de la batterie. L'élément de vérification peut comprendre un élément de comparaison des temps déterminés par le moyen de calcul et par l'élément de détermination.

Dans un tel cas, un élément 8 de détermination de la valeur caractéristique de la batterie est mis en oeuvre. Cet élément commande la mise en oeuvre d'une phase de charge et/ou de décharge de la batterie. L'élément de détermination peut comprendre des éléments de détermination, notamment de mesure, des courants de charge et de décharge de la batterie. L'élément de détermination peut également comprendre des éléments d'intégration temporelle de ces courants. L'élément de détermination peut alternativement ou complémentairement comprendre des moyens de détection de fin de charge et/ou de fin de décharge de la batterie.

L'élément de prévision du besoin en énergie du dispositif peut comprendre un élément d'interrogation de l'utilisateur et un élément d'interprétation d'une réponse de l'utilisateur, cet élément peut par exemple être un organe d'une interface homme-machine. Complémentairement ou alternativement, l'élément 6 de prévision du besoin en énergie du dispositif peut comprendre un circuit interne du dispositif comme une mémoire contenant une programmation des plages temporelles d'utilisation du dispositif.

Du fait des problèmes d'erreur sur la valeur de la caractéristique, il est proposé une solution de redétermination ou de recalage des valeurs de la caractéristique, notamment les valeurs de charge de la batterie Cr, de capacité de la batterie Cref, d'état de charge SOC et d'état de santé SOH. Cette solution consiste en une mise en oeuvre d'une procédure de détermination de la valeur de la caractéristique différente de celle utilisée habituellement, cette dernière conduisant à une erreur au bout d'un certain temps. Ceci est fait périodiquement ou occasionnellement en respectant plusieurs contraintes d'utilisation du système et d'environnement de celui-ci afin de garantir une gestion de la batterie utilisant des valeurs correctes d'état de charge SOC et/ou d'état de santé SOH.

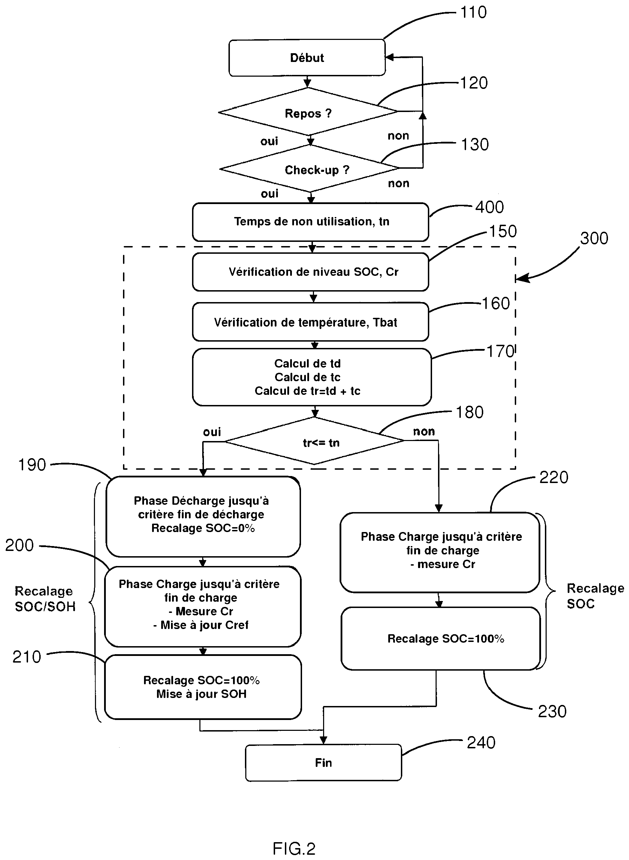

Un mode d'exécution d'un procédé de fonctionnement selon l'invention est décrit ci-après en référence à la figure 2.

Dans une première étape 130, on détecte un besoin de détermination d'une valeur d'une caractéristique de la batterie. Si tel est le cas, on passe à l'étape 300. Si tel n'est pas le cas, on boucle sur l'étape 110.

Puis dans une deuxième étape 300, on vérifie la possibilité de déterminer cette valeur de caractéristique vis-à-vis d'un besoin prévu en énergie du dispositif.

Puis, dans une troisième étape 190, on détermine la valeur de la caractéristique de la batterie, cette étape comprenant une phase de décharge complète de la batterie.

Dans le mode de réalisation représenté à la figure 2, plusieurs étapes sont préalables à l'étape 130.

De manière plus détaillée, dans une étape 110, on initialise le procédé.

Puis, dans une étape 120, on teste si la batterie alimente le dispositif. Si tel est le cas, on boucle sur l'étape 110. Si tel n'est pas le cas, on passe à l'étape 130.

Entre l'étape 130 et l'étape 300, on met en oeuvre une étape 400 dans laquelle on détermine la durée tn ou le temps durant lequel le dispositif n'utilisera pas ou n'aura pas besoin de l'énergie de la batterie. Cette étape est de préférence réalisée en interrogeant l'utilisateur.

L'étape 300 comprend les sous-étapes 150, 160, 170 et 180.

Dans la sous-étape 150, on détermine la valeur d'état de charge et/ou la valeur de charge de la batterie. En effet, il est possible de conditionner la suite du procédé à des valeurs d'état de charge ou de charge de la batterie.

Dans la sous-étape 160, on détermine la température de la batterie. En effet, il est possible de conditionner la suite du procédé à une valeur de température de la batterie.

Dans la sous-étape 170, on détermine la durée td nécessaire à la décharge complète de la batterie et la durée tc nécessaire à la charge complète de la batterie. On calcule enfin la durée totale tr de mise en oeuvre du procédé avec décharge totale de la batterie puis recharge totale de la batterie, avec tr=td+tc.

Dans la sous-étape 180, on teste s'il est possible de mettre en oeuvre une étape de décharge complète de la batterie puis une étape de charge complète de la batterie, par exemple, on teste si la durée tr est inférieure à la durée tn. Si tel est le cas, on passe à une étape 190. Si tel n'est pas le cas, on passe à une étape 220. Bien évidemment, on peut tenir compte du fait qu'il n'est pas toujours nécessaire que la batterie soit complètement rechargée lorsque l'utilisateur aura de nouveau besoin d'utiliser le dispositif consommateur.

Dans l'étape 190, on décharge la batterie complètement, c'est-à-dire jusqu'à ce qu'un critère de fin de décharge soit rempli. A la fin de l'étape de décharge, son état de charge SOC vaut donc 0%. Cette valeur d'état de charge est donc mise à jour dans le système de gestion de la batterie.

Puis, dans une étape 200, on charge la batterie complètement, c'est-à-dire jusqu'à ce qu'un critère de fin de charge soit rempli. Durant cette étape, on détermine la capacité et donc la charge transmise à la batterie. Pour ce faire, on peut par exemple déterminer, en particulier mesurer, le courant de charge de la batterie tout au long de l'étape. Ceci permet de déterminer la capacité Cr et de mettre à jour Cref de la batterie.

Puis, dans une étape 210, étant donné que la batterie est complètement chargée, son état de charge SOC vaut donc 100%. La capacité Cr de la batterie vaut la capacité réelle disponible Cref. La valeur d'état de charge est donc là encore mise à jour dans le système de gestion de la batterie SOC. Par ailleurs, il est alors possible de mettre à jour la valeur d'état de santé SOH, par exemple en calculant Cref/CrefO.

On passe ensuite à une étape de fin 240.

Dans l'étape 220, on charge la batterie complètement, c'est-à-dire jusqu'à ce qu'un critère de fin de charge soit rempli.

Dans l'étape 230, la batterie est complètement chargée, son état de charge SOC vaut donc 100%. La valeur d'état de charge est donc là encore mise à jour dans le système de gestion de la batterie SOC.

On passe ensuite à une étape de fin 240.

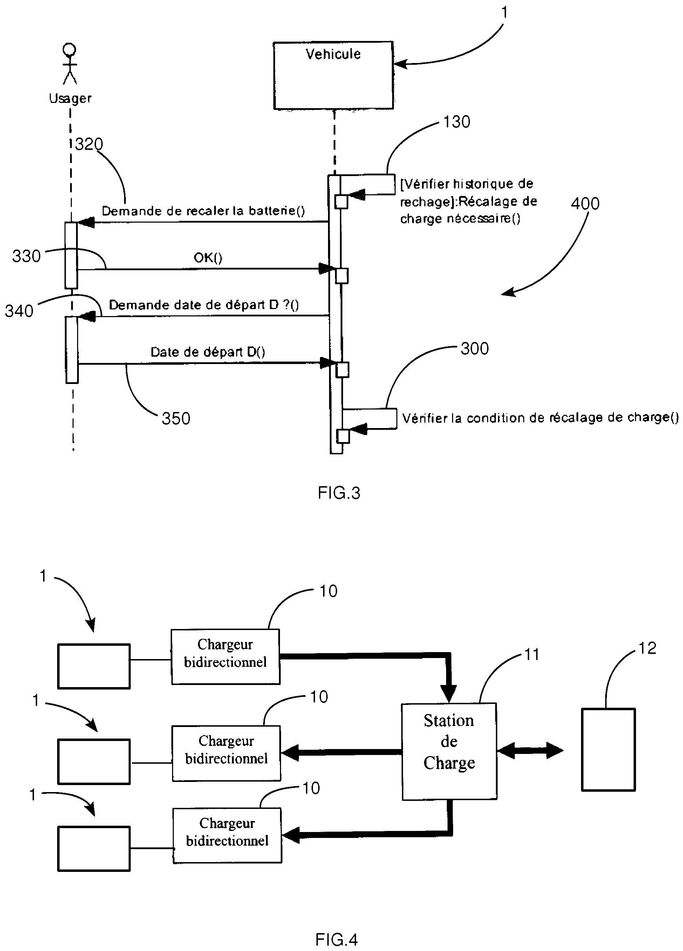

Dans une étape 400 décrite ci-après en référence à la figure 3 et faisant suite à l'étape 130, il peut y avoir un dialogue avec un utilisateur du dispositif, par exemple via l'interface homme-machine du dispositif.

Dans une première sous-étape 320, le dispositif demande à l'utilisateur s'il désire mettre en oeuvre les procédures permettant de recaler ou de redéterminer des caractéristiques de la batterie.

Dans une sous-étape 330, l'utilisateur répond au dispositif.

Dans une sous-étape 340, le dispositif demande à l'utilisateur de lui indiquer la durée pendant laquelle il n'utilisera pas le dispositif ou l'heure à laquelle il recommencera à utiliser le dispositif.

Dans une sous-étape 350, l'utilisateur répond au dispositif. Dans les deux cas, le dispositif peut donc déterminer la durée tn durant laquelle l'utilisateur ne devrait pas utiliser le dispositif.

Le procédé propose un recalage de Cr et de Cref en prenant en compte plusieurs contraintes telles que :
- contrainte d'utilisation du dispositif ou système par l'utilisateur,
- temps de non utilisation et temps d'utilisation du dispositif ou système,
- dans le cas d'un véhicule électrique : distance souhaitée à parcourir Dap,
- diagnostic régulier ou bien occasionnel suivant le souhait de l'utilisateur ou les contraintes technologiques ou de sécurité du dispositif,
- contraintes d'environnement,
- capacité de charge restante Cr,
- température de la batterie Tbat,
- type de système de charge et ou de décharge.

Le seuil de capacité de charge restante pour déterminer la condition de recalage est dynamique en fonction de différentes contraintes mentionnées ci-dessus. On préfère par exemple effectuer le recalage lorsque la charge de la batterie est déjà suffisamment faible, ce qui évite de devoir décharger presque toute la batterie, voire toute la batterie.

Le procédé est appliqué de préférence lors de phases où l'utilisateur souhaite recharger la batterie, par exemple pour un véhicule automobile pendant la nuit ou bien à la station de charge lors du travail.

Une commande de lancement du procédé peut être proposée dans le menu de l'interface homme-machine du système de gestion du fonctionnement du dispositif ou de la batterie. L'utilisateur peut ainsi lancer le procédé de sa propre initiative.

Le calcul du temps de décharge td évoqué plus haut prend en compte les caractéristiques du moyen de décharge du système de charge, la capacité restante de la batterie et la température de la batterie.

Le calcul du temps de charge tc pour atteindre la charge complète prend en compte les caractéristiques du moyen de charge du système de charge, la capacité de charge de la batterie et la température de la batterie.

Ce procédé selon l'invention est valable pour toutes technologies de batteries.

La figure 4 illustre le procédé selon l'invention appliquée à des véhicules automobile 1 se trouvant au niveau d'une station de charge 11 reliée à un réseau électrique 12, comme le réseau électrique commercial et comprenant plusieurs chargeurs 10, notamment des chargeurs bidirectionnels. Ainsi, lorsqu'il est décidé de décharger la batterie de l'un des véhicules, l'énergie de cette batterie peut être utilisée pour charger une ou plusieurs batteries d'autres véhicules reliés à la station de charge ou peut être injectée sur le réseau. Ce choix peut être fait selon la présence ou l'absence d'autres véhicules connectés à la station.

La phase de décharge peut être rapide (environ 30 minutes) ou lente (environ 2 heures) suivant le chargeur bidirectionnel utilisé. Pendant la phase de charge, le temps de charge est en général de 8 heures pour un système de charge lente de 3kW, 4 heures pour un système de charge moyenne de 6kW et 30 minutes pour un système de charge de 48kW.

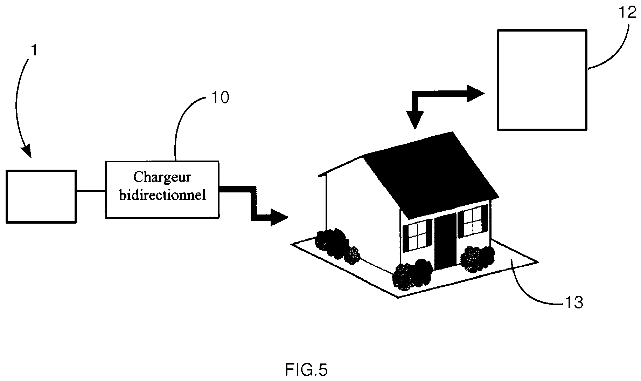

La figure 5 illustre le procédé selon l'invention appliquée à un véhicule automobile 1 se trouvant au niveau d'une habitation 13 reliée à un réseau électrique 12, comme le réseau électrique commercial et comprenant un chargeur 10, notamment un chargeur bidirectionnel. L'utilisateur peut raccorder son véhicule au système électrique de l'habitation. Dès que le procédé est lancé, la batterie du véhicule électrique est déchargée lors de la phase de décharge. L'énergie peut être utilisée pour la consommation générale dans l'habitation ou bien peut être injectée sur le réseau.

Comme cela ressort de l'exposé précédent, le procédé et le dispositif selon l'invention permettent de déterminer une valeur réelle d'une caractéristique par opposition à une valeur estimée, calculée, de cette caractéristique. Le procédé de détermination d'une valeur réelle d'une caractéristique permet de déterminer avec une bonne précision la valeur de la caractéristique, à un instant donné et dans des conditions de fonctionnement de la batterie prédéfinies, contrairement à des procédures d'estimation qui permettent de calculer une valeur instantanée en mettant en oeuvre des algorithmes de calcul à partir de mesures de grandeurs physiques, par exemple la tension de la batterie. Les valeurs estimées peuvent s'avérer peu précises en fonction notamment des conditions d'utilisation de la batterie et de son vieillissement.

Cette valeur réelle, déterminée à un instant donné, peut avantageusement être utilisée pour recaler une procédure d'estimation de la valeur caractéristique ou utilisée dans une procédure d'estimation de la valeur, pour éviter les dérives au cours du temps de ces procédures d'estimation.

Avantageusement, comme vu précédemment, on peut utiliser la valeur réelle préalablement déterminée pour une caractéristique d'état de charge SOC de la batterie, pour réinitialiser ou recaler la procédure d'estimation de l'état de charge.

Avantageusement aussi, au moins une valeur de l'état de santé SOH de la batterie ou la capacité Cref de la batterie est sauvegardée dans une mémoire. Ainsi, après détermination de la valeur réelle de l'état de santé SOH de la batterie ou de la capacité Cref de la batterie, cette valeur réelle est enregistrée dans ladite mémoire. En conséquence, à chaque mise en oeuvre de la procédure d'estimation, la valeur enregistrée en mémoire peut être utilisée. Par exemple, cette valeur peut être utilisée comme une constante dans une formule mathématique exprimant la valeur de l'état de santé SOH de la batterie ou de la capacité Cref de la batterie en fonction de différents paramètres mesurés ou estimés.

## Revendications

1. Procédé de fonctionnement d'un dispositif (4) de détermination d'une caractéristique d'une batterie parmi l'état de charge (SOC) de la batterie, l'état de santé (SOH) de la batterie et la capacité (Cref) de la batterie, le dispositif comprenant une interface homme-machine, le procédé comprenant les étapes suivantes :
- Recevoir une requête de détermination d'une valeur réelle de ladite caractéristique d'une batterie (3),
- Déterminer, en interrogeant un utilisateur via l'interface homme-machine, la prochaine date à laquelle un dispositif consommateur (9) aura besoin d'énergie de la batterie,
**caractérisé en ce que** le procédé comprend en outre les étapes suivantes :
- Vérifier qu'il est possible de déterminer la valeur réelle de la caractéristique de la batterie d'ici la prochaine date,
- Si tel est le cas, déterminer la valeur réelle de la caractéristique de la batterie en réalisant une phase de charge de la batterie ou en réalisant une phase de décharge et de charge de la batterie,
l'étape de vérification qu'il est possible de déterminer la valeur réelle de la caractéristique de la batterie d'ici la prochaine date à laquelle un dispositif consommateur aura besoin d'énergie de la batterie comprenant une validation confirmant qu'il n'est pas prévu que le dispositif utilise de l'énergie de la batterie pendant une durée au moins égale à la durée de l'étape de détermination de la valeur réelle de la caractéristique de la batterie.

2. Procédé de fonctionnement selon la revendication précédente, **caractérisé en ce qu'**il comprend l'étape suivante :
- Utiliser la valeur réelle préalablement déterminée pour ladite caractéristique de l'état de charge (SOC) de la batterie, pour réinitialiser ou recaler une procédure d'estimation, notamment d'estimation en temps réel, de la valeur de l'état de charge de la batterie.

3. Procédé de fonctionnement selon la revendication 1, **caractérisé en ce que** la caractéristique est l'état de santé (SOH) de la batterie ou la capacité (Cref) de la batterie, **en ce qu'**au moins une valeur de ladite caractéristique est sauvegardée dans une mémoire et **en ce que**, après détermination de la valeur réelle de la caractéristique, cette valeur réelle est enregistrée dans ladite mémoire.

4. Procédé de fonctionnement selon l'une des revendications précédentes, **caractérisé en ce que** l'étape de détermination de la valeur réelle de la caractéristique de la batterie comprend une phase de décharge de la batterie, notamment une phase de décharge complète ou partielle de la batterie, puis une phase de charge de la batterie, notamment une phase de charge complète ou partielle de la batterie.

5. Procédé selon l'une des revendications précédentes, **caractérisé en ce que** l'étape de détermination de la valeur réelle de la caractéristique de la batterie comprend une phase de charge complète de la batterie.

6. Procédé selon la revendication précédente, **caractérisé en ce qu'**on détermine l'intensité du courant de charge de la batterie pendant toute la phase de charge de la batterie et on utilise cette intensité pour déterminer le niveau de la charge de la batterie à la fin de la phase de charge.

7. Procédé selon l'une des revendications précédentes, **caractérisé en ce que** l'étape de détermination de la valeur réelle de la caractéristique de la batterie comprend une phase de décharge complète de la batterie.

8. Procédé selon l'une des revendications précédentes, **caractérisé en ce qu'**on détermine l'intensité du courant de décharge de la batterie pendant toute la phase de décharge de la batterie et on utilise cette intensité pour déterminer le niveau de la charge de la batterie à la fin de la phase de décharge.

9. Procédé selon l'une des revendications précédentes, **caractérisé en ce que** l'étape de réception d'une requête de détermination d'une valeur réelle de la caractéristique de la batterie comprend la détection d'une échéance d'une temporisation déclenchée lors d'une étape de détermination précédente et/ou une détection d'une volonté de détermination exprimée par l'utilisateur du dispositif.

10. Procédé selon l'une des revendications précédentes, **caractérisé en ce que** l'énergie issue de la batterie pendant la décharge de la batterie est :
- utilisée pour recharger au moins une autre batterie ; et/ou
- utilisée dans une habitation à laquelle le dispositif est électriquement connecté ; et/ou
- injectée sur un réseau électrique, notamment le réseau électrique commercial.

11. Support d'enregistrement de données lisible par un calculateur sur lequel est enregistré un programme d'ordinateur comprenant des moyens logiciels de mise en oeuvre des étapes du procédé selon l'une des revendications précédentes.

12. Dispositif (4) de détermination d'une caractéristique d'une batterie parmi l'état de charge (SOC) de la batterie, l'état de santé (SOH) de la batterie et la capacité (Cref) de la batterie, le dispositif comprenant une interface homme-machine, **caractérisé en ce qu'**il comprend des éléments matériels (5, 6, 7, 8) et/ou logiciels de mise en oeuvre des étapes du procédé selon l'une des revendications 1 à 10, les éléments matériels et/ou logiciel comprenant :
- Un élément (5) de réception d'une requête de détermination d'une valeur réelle de la caractéristique d'une batterie,
- Un élément (6) de détermination, en interrogeant un utilisateur, de la prochaine date à laquelle un dispositif consommateur (9) aura besoin d'énergie de la batterie,
- Un élément (7) de vérification qu'il est possible de déterminer la valeur réelle de la caractéristique de la batterie d'ici la prochaine date,
- Un élément (8) de détermination de la valeur réelle de la caractéristique de la batterie en réalisant une phase de charge et/ou de décharge de la batterie.

13. Système (1), notamment véhicule automobile, comprenant un dispositif (4) selon la revendication précédente, une batterie (3) et un dispositif consommateur (9).

## Patentansprüche

1. Verfahren zum Betreiben einer Vorrichtung (4) zum Bestimmen einer Eigenschaft einer Batterie aus dem Ladezustand (SOC) der Batterie, dem Gesundheitszustand (SOH) der Batterie und der Kapazität (Cref) der Batterie, wobei die Vorrichtung eine Mensch-Maschine-Schnittstelle umfasst und das Verfahren die folgenden Schritte umfasst:
- Empfangen einer Anforderung zum Bestimmen eines Istwerts der Eigenschaft einer Batterie (3),
- Bestimmen des nächsten Datums, an dem eine Verbrauchervorrichtung (9) Batteriestrom benötigt, durch Abfrage eines Benutzers über die Mensch-Maschine-Schnittstelle, **dadurch gekennzeichnet, dass** das Verfahren ferner die folgenden Schritte umfasst:
- Überprüfen, ob es möglich ist, den Istwert der Batterieeigenschaft bis zum nächsten Datum zu bestimmen,
- Wenn dies der Fall ist, bestimmen des Istwerts der Batterieeigenschaft durch Durchführen einer Batterieladephase oder durch Durchführen einer Batterieentlade- und -ladephase, wobei der Überprüfungsschritt, ob es möglich ist, den Istwert der Batterieeigenschaft bis zum nächsten Datum zu bestimmen, an dem eine Verbrauchervorrichtung Batterieenergie benötigt, eine Validierung umfasst, die bestätigt, dass nicht vorgesehen ist, dass die Vorrichtung während einer Dauer, die mindestens gleich der Dauer des Schritts zum Bestimmen des Istwerts der Batterieeigenschaft ist, Batterieenergie verwendet.

2. Betriebsverfahren nach dem vorhergehenden Anspruch, **dadurch gekennzeichnet, dass** es den folgenden Schritt umfasst:
- Verwenden des zuvor für die Batterie-Ladezustandseigenschaft (SOC) bestimmten Istwerts, um ein Schätzverfahren, insbesondere eine Echtzeit-Schätzung, des Werts des Ladezustands der Batterie zurückzusetzen oder neu einzurichten.

3. Betriebsverfahren nach Anspruch 1, **dadurch gekennzeichnet, dass** die Eigenschaft der Gesundheitszustand (SOH) der Batterie oder die Kapazität (Cref) der Batterie ist, dass mindestens ein Wert der Eigenschaft in einem Speicher gespeichert wird und dass nach dem Bestimmen des Istwerts der Eigenschaft dieser Istwert in dem Speicher aufgezeichnet wird.

4. Betriebsverfahren nach einem der vorhergehenden Ansprüche, **dadurch gekennzeichnet, dass** der Schritt zum Bestimmen des Istwerts der Batterieeigenschaft eine Batterieentladephase, insbesondere eine vollständige oder teilweise Batterieentladephase, und anschließend eine Batterieladephase, insbesondere eine vollständige oder teilweise Batterieladephase, umfasst.

5. Verfahren nach einem der vorhergehenden Ansprüche, **dadurch gekennzeichnet, dass** der Schritt zum Bestimmen des Istwerts der Batterieeigenschaft eine vollständige Batterieladephase umfasst.

6. Verfahren nach dem vorhergehenden Anspruch, **dadurch gekennzeichnet, dass** während der gesamten Batterieladephase die Intensität des Ladestroms der Batterie bestimmt wird und diese Intensität zum Bestimmen des Niveaus der Batterieladung am Ende der Ladephase verwendet wird.

7. Verfahren nach einem der vorhergehenden Ansprüche, **dadurch gekennzeichnet, dass** der Schritt zum Bestimmen des Istwerts der Batterieeigenschaft eine vollständige Batterieentladephase umfasst.

8. Verfahren nach einem der vorstehenden Ansprüche, **dadurch gekennzeichnet, dass** die Intensität des Entladestroms der Batterie während der gesamten Batterieentladephase bestimmt wird und diese Intensität zum Bestimmen des Niveaus der Batterieladung am Ende der Entladephase verwendet wird.

9. Verfahren nach einem der vorhergehenden Ansprüche, **dadurch gekennzeichnet, dass** der Schritt des Empfangens einer Anforderung zum Bestimmen eines Istwerts der Batterieeigenschaft das Erfassen einer Zeitbegrenzung einer Verzögerung, die in einem vorhergehenden Bestimmungsschritt ausgelöst wird, und/oder ein Erfassen eines vom Benutzer der Vorrichtung ausgedrückten Bestimmungswunsches umfasst.

10. Verfahren nach einem der vorhergehenden Ansprüche, **dadurch gekennzeichnet, dass** die Energie aus der Batterie während der Entladung der Batterie:
- zum Aufladen mindestens einer weiteren Batterie verwendet wird; und/oder
- in einer Wohnung verwendet wird, mit der die Vorrichtung elektrisch verbunden ist; und/oder
- in ein Stromnetz eingespeist wird, insbesondere das gewerbliche Stromnetz.

11. Datenaufzeichnungsmedium, das von einem Rechner lesbar ist, auf dem ein Computerprogramm gespeichert ist, umfassend Softwaremittel zum Ausführen von Schritten des Verfahrens gemäß einem der vorhergehenden Ansprüche.

12. Vorrichtung (4) zum Bestimmen einer Eigenschaft einer Batterie aus dem Ladezustand (SOC) der Batterie, dem Gesundheitszustand (SOH) der Batterie und der Kapazität (Cref) der Batterie, wobei die Vorrichtung eine Mensch-Maschine-Schnittstelle umfasst, **dadurch gekennzeichnet, dass** sie Hardware- (5, 6, 7, 8) und/oder Software-Elemente zur Ausführung von Verfahrensschritten nach einem der Ansprüche 1 bis 10 umfasst, wobei die Hardware- und/oder Software-Elemente umfassen:
- ein Element (5) zum Empfangen einer Anforderung zum Bestimmen eines Istwerts einer Eigenschaft einer Batterie,
- ein Element (6) zum Bestimmen des nächsten Datums, an dem eine Verbrauchervorrichtung (9) Batteriestrom benötigt, durch Abfrage eines Benutzers,
- ein Element (7) zur Überprüfung, ob es möglich ist, den Istwert der Batterieeigenschaft bis zum nächsten Datum zu bestimmen,
- ein Element (8) zum Bestimmen des Istwerts der Batterieeigenschaft durch Durchführen einer Batterielade- und/oder -entladephase.

13. System (1), insbesondere Kraftfahrzeug, umfassend eine Vorrichtung (4) nach dem vorstehenden Anspruch, eine Batterie (3) und eine Verbrauchervorrichtung (9).

## Claims

1. Method of operation of a device (4) for determining a feature of a battery from among the state of charge (SOC) of the battery, the state of health (SOH) of the battery and the capacity (Cref) of the battery, the device comprising a man-machine interface, the method comprising the following steps:
- Receiving a request to determine an actual value of the said feature of a battery (3),
- Determining, by interrogating a user via the man-machine interface, the next date at which a consuming device (9) will need energy from the battery,
wherein the method comprises the following steps:
- Verifying that it is possible to determine the actual value of the feature of the battery by the next date,
- If such is the case, determining the actual value of the feature of the battery by carrying out a phase of charging of the battery or by carrying out a phase of discharging of the battery,
the step of verifying that it is possible to determine the actual value of the feature of the battery by the next date at which a consuming device will need energy from the battery comprising a validation confirming that the device is not forecast to use energy from the battery for a duration at least equal to the duration of the step of determining the actual value of the feature of the battery.

2. Method of operation according to the preceding claim, **characterized in that** it comprises the following step:
- Using the previously determined actual value for the said feature of the state of charge (SOC) of the battery, to reinitialize or adjust a procedure for estimating, in particular for estimating in real time, the value of the state of charge of the battery.

3. Method of operation according to Claim 1, **characterized in that** the feature is the state of health (SOH) of the battery or the capacity (Cref) of the battery, **in that** at least one value of the said feature is saved in a memory and **in that**, after determination of the actual value of the feature, this actual value is recorded in the said memory.

4. Method of operation according to one of the preceding claims, **characterized in that** the step of determining the actual value of the feature of the battery comprises a phase of discharging of the battery, in particular a phase of complete or partial discharging of the battery, and then a phase of charging of the battery, in particular a phase of complete or partial charging of the battery.

5. Method according to one of the preceding claims, **characterized in that** the step of determining the actual value of the feature of the battery comprises a phase of complete charging of the battery.

6. Method according to the preceding claim, **characterized in that** the intensity of the battery charging current is determined throughout the battery charging phase and this intensity is used to determine the level of the charge of the battery at the end of the charging phase.

7. Method according to one of the preceding claims, **characterized in that** the step of determining the actual value of the feature of the battery comprises a phase of complete discharging of the battery.

8. Method according to one of the preceding claims, **characterized in that** the intensity of the battery discharge current is determined throughout the battery discharging phase and this intensity is used to determine the level of the charge of the battery at the end of the discharging phase.

9. Method according to one of the preceding claims, **characterized in that** the step of receiving a request to determine an actual value of the feature of the battery comprises the detection of a deadline of a time delay triggered during a previous determination step and/or a detection of a wish for determination expressed by the user of the device.

10. Method according to one of the preceding claims, **characterized in that** the energy arising from the battery during the discharging of the battery is:
- used to recharge at least one other battery; and/or
- used in a residence to which the device is electrically connected; and/or
- fed into an electrical network, in particular the commercial electrical network.

11. Data recording medium readable by a calculator on which is recorded a computer program comprising software means for implementing the steps of the method according to one of the preceding claims.

12. Device (4) for determining a feature of a battery from among the state of charge (SOC) of the battery, the state of health (SOH) of the battery and the capacity (Cref) of the battery, the device comprising a man-machine interface, **characterized in that** it comprises hardware (5, 6, 7, 8) and/or software elements for implementing the steps of the method according to one of Claims 1 to 10, the hardware and/or software elements comprising:
- An element (5) for receiving a request to determine an actual value of the feature of a battery,
- An element (6) for determining, by interrogating a user, the next date at which a consuming device (9) will need energy from the battery,
- An element (7) for verifying that it is possible to determine the actual value of the feature of the battery by the next date,
- An element (8) for determining the actual value of the feature of the battery by carrying out a phase of charging and/or discharging of the battery.

13. System (1), in particular automotive vehicle, comprising a device (4) according to the preceding Claim, a battery (3) and a consuming device (9).
